# FASCICULE DE BREVET EUROPEEN

(11) **EP 3 890 024 B1**
(45) Date de publication et mention de la délivrance du brevet: **01.05.2024**
(21) Numéro de dépôt: 21165104.7
(22) Date de dépôt: 26.03.2021
(51) Int. Cl.: H10B 63/10, H10N 70/20

(54) **PUCE ÉLECTRONIQUE À DEUX MÉMOIRES À CHANGEMENT DE PHASE ET PROCÉDÉ DE FABRICATION**
ELEKTRONISCHER CHIP MIT ZWEI PHASENWECHSELSPEICHERN UND HERSTELLUNGSVERFAHREN
ELECTRONIC CHIP WITH TWO PHASE CHANGE MEMORIES AND METHOD OF FABRICATION

(30) Priorité: 30.03.2020 FR 2003106
(43) Date de publication de la demande: 06.10.2021
(73) Titulaire: STMicroelectronics (Crolles 2) SAS, 38920 Crolles (FR)
(72) Inventeur: BERTHELON, Remy, 38400 Saint Martin d'Hères (FR); ARNAUD, Franck, 38330 St Nazaire les Eymes (FR)
(74) Mandataire: Cabinet Beaumont

(56) Documents cités:
- US-A1- 2004 042 298
- US-A1- 2008 068 879
- US-A1- 2013 181 183

## Description

### Domaine technique

La présente description se rapporte au domaine des puces électroniques, et plus précisément à une puce électronique à deux mémoires à changement de phase, ainsi que son procédé de fabrication.

### Technique antérieure

Une puce électronique, également appelée circuit intégré, comprend plusieurs composants électroniques sur semi-conducteur. Un exemple de l'art antérieur est le document US 2013/181183.

On distingue par exemple la mémoire vive et la mémoire non vive. La mémoire vive est la mémoire informatique dans laquelle peuvent être stockées, puis effacées, les données traitées par le processeur. Elle se caractérise principalement par sa rapidité d'accès (en lecture/écriture), essentielle pour fournir rapidement les données au processeur. La mémoire vive est généralement volatile en ce que les données qui y sont stockées sont perdues en cas de mise hors tension. Certaines mémoires vives peuvent cependant être non volatiles, quoiqu'avec des temps d'accès généralement plus longs. Dans la plupart des cas, la mémoire vive n'a pas à présenter une capacité de rétention importante puisque les données stockées en mémoire sont souvent modifiées. En raison des exigences de rapidité requises par des fonctions telle que cache de processeur (entre quelques nanosecondes ou centaines de nanosecondes), une mémoire vive est généralement une mémoire à accès aléatoire (ou RAM pour l'anglais "random-access memory") avec une architecture basée sur des transistors. Par exemple, la mémoire vive statique (ou SRAM de l'anglais "Static Random Access Memory") est un type de mémoire vive utilisant des bascules pour mémoriser les données, dont une cellule élémentaire peut comprendre jusqu'à six transistors (au moins quatre formant deux inverseurs à couplage transversal), tandis qu'une cellule de mémoire vive dynamique (ou DRAM pour l'anglais "Dynamic Random Access Memory") comprend généralement un condensateur et un transistor d'accès.

La mémoire non vive est une mémoire de grande capacité, non volatile, destinée à stocker des informations sur le long terme (typiquement plusieurs années). En contrepartie de cette exigence de rétention, une mémoire non vive peut présenter des temps d'accès sensiblement plus longs que ceux d'une mémoire vive, puisque les données qui y sont stockées sont moins utilisées (sinon elles sont mises en cache dans une mémoire volatile). Par exemple, une puce électronique peut présenter des modules de mémoire flash en tant que mémoire non volatile, dans laquelle les données sont stockées dans un transistor MOS grâce au piégeage d'électrons par une grille flottante enfouie au milieu de l'oxyde de grille, entre le canal et la grille.

Si ces architectures présentent plusieurs avantages, et notamment des temps d'accès très bas, elles présentent également des inconvénients notables. Un inconvénient important tient à l'encombrement significatif induit par leurs structures, qui limite la densité maximale pouvant être obtenu. Or, une haute densité de mémoire est particulièrement utile car une densité importante permet d'augmenter la quantité de mémoire sans consommation additionnelle de semiconducteur. En outre, une densité de mémoire plus élevée permet également d'obtenir des performances plus élevées. La densité des mémoires vives a jusqu'à présent été continuellement augmentée en réduisant les tailles des composants de ces mémoires, mais cette approche présente des limites, à la fois technologiques et économiques.

Une contrainte posée par la fabrication de mémoire est que le procédé de fabrication doit permettre de fabriquer, sur un même circuit intégré et avec des étapes de fabrication compatibles, des mémoires vives et des mémoires non-vives avec des caractéristiques différentes, notamment en temps d'accès. Cette contrainte a jusqu'ici limité les tentatives d'augmentation de la densité de mémoire autrement que par la réduction de tailles des cellules mémoires, sans modification de leurs structures.

### Résumé de l'invention

Il existe un besoin de permettre de faire cohabiter sur une même puce électronique, des mémoires présentant des caractéristiques différentes tout en dépassant les limites de densité mémoire des mémoires vives.

A cet effet, il est ici proposé une puce électronique comprenant au moins une première matrice de premières cellules élémentaires et une seconde matrice de secondes cellules élémentaires, chaque cellule élémentaire stockant chacune au moins un bit de données dans un élément de stockage présentant un état fonction du bit stocké, les deux matrices de cellules élémentaires formant deux types de mémoire à changement de phase dans lequel l'élément de stockage est formé par un volume de matériau à changement de phase configuré pour présenter soit un état cristallin soit un état amorphe en fonction du bit stocké, chaque première cellule élémentaire comprenant un volume d'un premier matériau, et chaque seconde cellule élémentaire comprenant un volume d'un second matériau, différent du premier matériau, le second matériau présentant soit un état cristallin soit un état amorphe en fonction du bit stocké, chaque cellule élémentaire comprenant un connecteur de chauffe configuré pour le passage d'un courant de chauffe adapté pour engendrer un changement de phase du volume de matériau à changement de phase de ladite cellule élémentaire

La puce électronique est complétée par les différentes caractéristiques suivantes prises seules ou selon leurs différentes combinaisons possibles :
- le second matériau présente une température de fusion inférieure à une température de fusion du premier matériau d'au moins 50°C, de préférence inférieure à la température de fusion du premier matériau d'au moins 80°C, et de préférence encore inférieure à la température de fusion du premier matériau d'au moins 120°C ;
- le premier matériau et le second matériau sont des chalcogénures, et de préférence sont des composés ternaires de chalcogénure ;
- le premier matériau et le second matériau à changement de phase sont en germanium-antimoine-tellure, le premier matériau présentant une teneur en germanium au moins trois fois plus importante que celle du second matériau, et le second matériau présentant une teneur en antimoine au moins trois fois plus importante que celle du premier matériau ;
- le premier matériau est en germanium-antimoine-tellure avec une teneur en germanium supérieure à 60%, et le second matériau est en germanium-antimoine-tellure avec une teneur en antimoine supérieure à 60% ;
- lequel l'élément de stockage d'une première cellule élémentaire est constitué par le volume de premier matériau à changement de phase, et l'élément de stockage d'une seconde cellule élémentaire comprend le volume de second matériau à changement de phase ;
- le volume de second matériau à changement de phase d'une seconde cellule élémentaire correspond à un connecteur de chauffe inférieur en contact avec un contact métallique traversant une couche d'isolation.

L'invention concerne également un procédé de fabrication d'une puce électronique selon l'invention, comprenant :
a) la fourniture d'une amorce de puce électronique issue d'une fabrication comprenant une pluralité de contacts métalliques traversant une première couche d'isolation, une première zone de la puce électronique correspondant aux premières cellules élémentaires à réaliser et une deuxième zone de la puce électronique correspondant aux secondes cellules élémentaires à réaliser,
b) la réalisation sur la première couche d'isolation de connecteurs de chauffe inférieurs traversant une couche intermédiaire adaptée pour connecter au moins les contacts métalliques de la première zone, des espaceurs étant interposés entre des connecteurs de chauffe inférieurs adjacents,
c) les dépôts successifs des deux matériaux à changement de phase, le premier matériau étant déposé sur la couche intermédiaire au contact de connecteurs de chauffe inférieurs, et des conducteurs supérieurs étant formés au-dessus du premier matériau par le dépôt d'une seconde couche conductrice, tandis que le second matériau est déposé suite à la réalisation d'au moins d'un espace préalablement gravé dans une deuxième zone correspondant aux secondes cellules élémentaires en utilisant un premier masque de gravure présentant une ouverture au droit de ladite deuxième zone, le second matériau étant déposé dans cet espace préalablement gravé, le second matériau étant ensuite retiré d'au moins la première zone,
d) gravure de séparation des premières cellules élémentaires et des secondes cellules élémentaires,
e) formation de couches d'isolation entre les premières cellules élémentaires et des secondes cellules élémentaires, et métallisation formant des lignes conductrices connectant les conducteurs supérieurs des premières cellules élémentaires et des secondes cellules élémentaires.

L'étape c) peut comprendre les sous-étapes suivantes :
c1) dépôt du premier matériau sur la couche intermédiaire au contact de connecteurs de chauffe inférieurs,
c2) dépôt d'une couche conductrice sur le premier matériau, destinée à former des conducteurs supérieurs pour les premières cellules élémentaires,
c3) mise en place du premier masque de gravure présentant une ouverture au droit de la deuxième zone, et gravure de la couche conductrice et du premier matériau pour réaliser l'espace préalablement gravé au niveau de la deuxième zone,
c4) dépôt du second matériau au niveau de la première zone et de la deuxième zone, le second matériau étant, dans la deuxième zone, au contact de connecteurs de chauffe inférieurs, et dépôt d'une couche conductrice sur le second matériau, destinée à former des connecteurs supérieurs pour les secondes cellules élémentaires,
c5) mise en place d'un second masque de gravure couvrant un espace de la deuxième zone et laissant dégagée la première zone, et retrait du second matériau de la première zone.

Au cours de l'étape b), les connecteurs de chauffe inférieurs peuvent être au contact des contacts métalliques de la première zone et de la deuxième zone.

L'étape c) peut comprendre les sous-étapes suivantes :
c1') mise en place du premier masque de gravure présentant une ouverture découvrant la deuxième zone, et gravure de la couche intermédiaire jusqu'à la première couche d'isolation,
c2') dépôt du second matériau, ledit second matériau étant au contact de contacts métalliques de la deuxième zone,
c3') retrait du second matériau de la première zone pour dégager la couche intermédiaire,
c4') dépôt du premier matériau au niveau de la première zone et de la deuxième et dépôt d'une couche conductrice sur le premier matériau, destinée à former des conducteurs supérieurs.

Au cours de l'étape b), les connecteurs de chauffe inférieurs sont alors au contact des contacts métalliques de la première zone seulement.

### Brève description des dessins

D'autres caractéristiques, buts et avantages du procédé ressortiront de la description qui suit, qui est purement illustrative et non limitative, et qui doit être lue en regard des dessins annexés sur lesquels :
la figure 1 montre la puce électronique résultant du premier procédé de fabrication selon un mode de réalisation possible de l'invention,
la figure 2 montre une étape d'un premier procédé de fabrication d'une puce électronique selon un mode de réalisation possible de l'invention,
la figure 3 montre une étape du premier procédé de fabrication d'une puce électronique selon un mode de réalisation possible de l'invention, qui fait suite à la figure 2,
la figure 4 montre une étape du premier procédé de fabrication d'une puce électronique selon un mode de réalisation possible de l'invention, qui fait suite à la figure 3,
la figure 5 montre une étape du premier procédé de fabrication d'une puce électronique selon un mode de réalisation possible de l'invention, qui fait suite à la figure 4,
la figure 6 montre une étape du premier procédé de fabrication d'une puce électronique selon un mode de réalisation possible de l'invention, qui fait suite à la figure 5,
la figure 7 montre une étape du premier procédé de fabrication d'une puce électronique selon un mode de réalisation possible de l'invention, qui fait suite à la figure 6,
la figure 8 montre une étape du premier procédé de fabrication d'une puce électronique selon un mode de réalisation possible de l'invention, qui fait suite à la figure 7,
la figure 9 montre une étape du premier procédé de fabrication d'une puce électronique selon un mode de réalisation possible de l'invention, qui fait suite à la figure 8,
la figure 10 montre une étape du premier procédé de fabrication d'une puce électronique selon un mode de réalisation possible de l'invention, qui fait suite à la figure 9,
la figure 11 montre la puce électronique résultant du second procédé de fabrication selon un mode de réalisation possible de l'invention,
la figure 12 montre une étape d'un second procédé de fabrication d'une puce électronique selon un mode de réalisation possible de l'invention,
la figure 13 montre une étape du second procédé de fabrication d'une puce électronique selon un mode de réalisation possible de l'invention, qui fait suite à la figure 12,
la figure 14 montre une étape du second procédé de fabrication d'une puce électronique selon un mode de réalisation possible de l'invention, qui fait suite à la figure 13,
la figure 15 montre une étape du second procédé de fabrication d'une puce électronique selon un mode de réalisation possible de l'invention, qui fait suite à la figure 14,
la figure 16 montre une étape du second procédé de fabrication d'une puce électronique selon un mode de réalisation possible de l'invention, qui fait suite à la figure 12,
la figure 17 montre une étape du second procédé de fabrication d'une puce électronique selon un mode de réalisation possible de l'invention, qui fait suite à la figure 16, et
la figure 18 montre une étape du second procédé de fabrication d'une puce électronique selon un mode de réalisation possible de l'invention, qui fait suite à la figure 17.

### Description des modes de réalisation

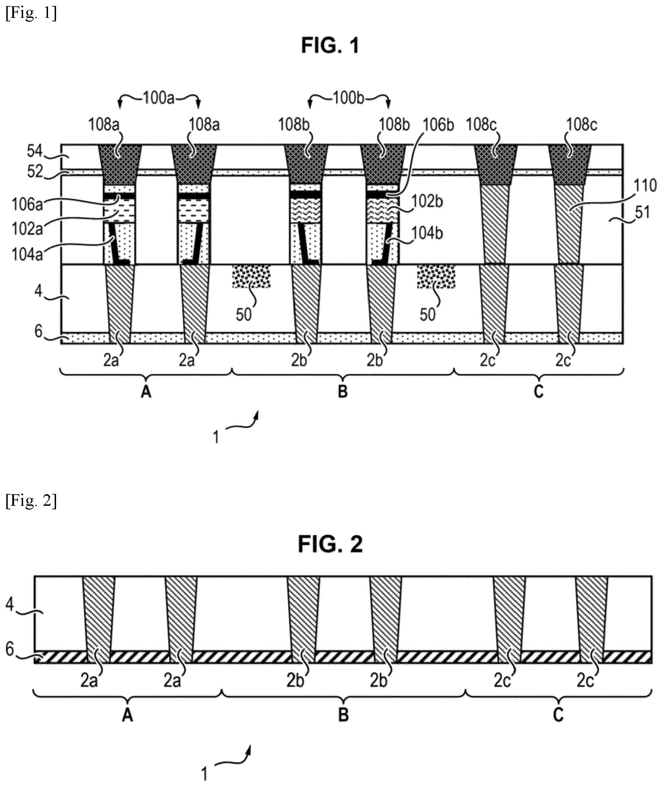

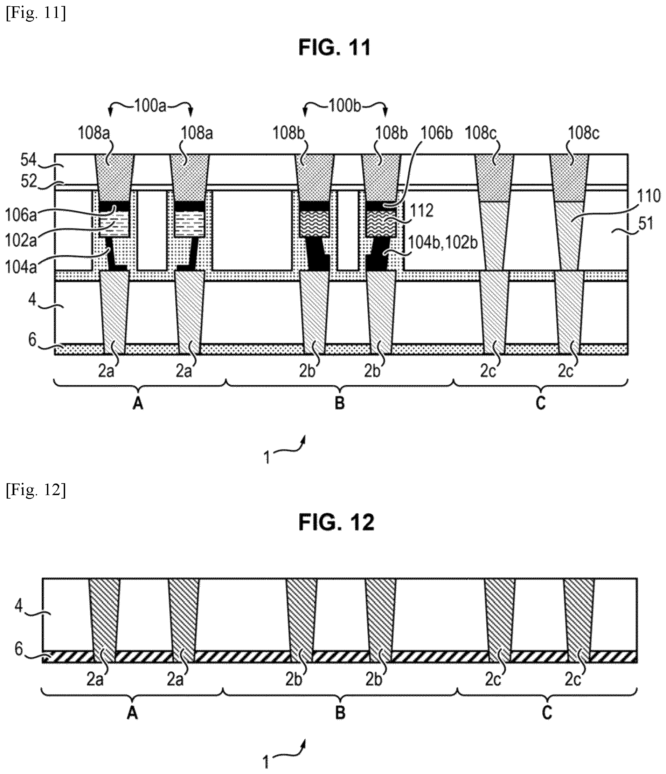

En référence aux figures 1 et 11, une puce électronique comprend au moins une première matrice de premières cellules élémentaires 100a et une seconde matrice de secondes cellules élémentaires 100b, chaque cellule élémentaire 100a, 100b étant configurée pour stocker chacune au moins un bit de données dans un élément de stockage présentant un état fonction du bit stocké. Les premières cellules élémentaires 100a sont situées dans une première zone A de la puce électronique, tandis que les secondes cellules élémentaires 100b sont situées dans une deuxième zone B de la puce électronique.

Les deux matrices de cellules élémentaires 100a, 100b forment deux types de mémoire à changement de phase dans lequel l'élément de stockage est formé par un volume 102a, 102b de matériau à changement de phase présentant soit un état cristallin soit un état amorphe en fonction du bit stocké. Chaque première cellule élémentaire 100a comprend un volume 102a d'un premier matériau, et chaque seconde cellule élémentaire 100b comprend un volume 102b d'un second matériau, différent du premier matériau. Le second matériau présente une température de fusion inférieure à la température de fusion du premier matériau d'au moins 50°C, et de préférence inférieure à celle du premier matériau d'au moins 80°C, et de préférence encore inférieure à celle du premier matériau d'au moins 120°C. De préférence, le premier matériau à changement de phase est un chalcogénure, et de préférence encore est un composé ternaire de chalcogénure. De préférence, le premier matériau présente une teneur en germanium au moins trois fois plus importante que celle du second matériau, et le second matériau présentant une teneur en antimoine au moins trois fois plus importante que celle du premier matériau. En particulier, le premier matériau peut être en germanium-antimoine-tellure (GeSbTe), avec une teneur majoritaire en germainum, supérieure à 60%, et de préférence supérieure à 70%, et de préférence encore d'au moins 80%. De préférence, le second matériau est un chalcogénure, et de préférence encore est un composé ternaire de chalcogénure. En particulier, le second matériau peut être en germanium-antimoine-tellure (GeSbTe), avec une teneur majoritaire en antimoine, supérieure à 60%, et de préférence supérieure à 70%, et de préférence encore d'au moins 80%.

Dans des modes de réalisation telles que ceux illustrés par les figures 1 et 11, une première cellule 100a comprend, au-dessus d'un contact métallique 2a, un volume 102a de premier matériau à changement de phase encadré par un connecteur de chauffe inférieur 104a, et par un conducteur supérieur 106a. Dans cette première cellule élémentaire 100a, l'élément de stockage présentant soit un état cristallin soit un état amorphe en fonction du bit stocké est constitué par le volume 102a de premier matériau à changement de phase.

Dans un mode de réalisation tel que celui illustré par la figure 1, une deuxième cellule 100b comprend, au-dessus d'un contact métallique 2b, un volume 102b de second matériau à changement de phase encadré par un connecteur de chauffe inférieur 104b, et par un conducteur supérieur 106b. Dans cette deuxième cellule élémentaire 100b, l'élément de stockage présentant soit un état cristallin soit un état amorphe en fonction du bit stocké est constitué par le volume 102b de second matériau à changement de phase.

Dans un mode de réalisation tel que celui illustré par la figure 11, une deuxième cellule 100b comprend, au-dessus d'un contact métallique 2b, un volume 102b de second matériau à changement de phase formant connecteur de chauffe inférieur 104b, avec au-dessus un volume 112 de premier matériau à changement de phase surmonté d'un conducteur supérieur 106b. Dans cette deuxième cellule élémentaire 100b, l'élément de stockage présentant soit un état cristallin soit un état amorphe en fonction du bit stocké comprend au moins le volume 102b de second matériau à changement de phase formant connecteur de chauffe inférieur 104b, et éventuellement également le volume 112 de premier matériau à changement de phase.

Il va maintenant être décrit plusieurs procédés de fabrication d'une puce électronique comprenant au moins une première matrice de premières cellules élémentaires et une seconde matrice de cellules élémentaires formant deux types de mémoire à changement de phase. Dans la description qui suit, le terme gravure est employé de façon large, pour désigner le retrait d'une ou plusieurs couches de matières à la surface de la plaquette (ou "wafer"). La gravure peut être humide ou sèche, et peut par exemple être mise en œuvre dans le cadre d'un procédé de photolithographie, et peut donc correspondre à des procédés tels que la structuration (ou "patterning" en anglais).

### Premier procédé de fabrication

En référence aux figures 1 à 10, un premier procédé de fabrication permet d'obtenir une telle puce électronique. Une première étape du procédé comprend la fourniture d'une amorce 1 de puce électronique issue d'une fabrication initiale (plus connu sous le terme anglais de "Front-end-of-Line" ou FEOL), qui est illustrée par la figure 2. Afin de simplifier la description, il ne sera traité ici que les parties de la fabrication correspondant à la fabrication de la première matrice de cellules élémentaires et de la seconde matrice de cellules élémentaires formant deux types de mémoire à changement de phase. Les autres parties (processeurs, autres mémoires, transistors à effet de champs, etc.) ne sont ni représentées dans les figures, ni détaillées ici, bien qu'elles soient également présentes lors de la fabrication.

Dans le cas présent, l'amorce 1 présente donc à la surface d'un substrat les dispositifs tels que les transistors et les sélecteurs qui forment une partie de la logique des mémoires. Cette partie n'est pas représentée sur les figures, dans la mesure où il s'agit d'une partie connue de l'homme du métier, non impactée par l'invention. De préférence, le substrat est formé de silicium sur isolant. L'amorce 1 comprend une pluralité de contacts métalliques 2a, 2b, 2c (par exemple en tungstène) traversant une première couche d'isolation 4, par exemple en Si02, qui peut être formée à la surface d'une couche de passivation 6, par exemple en nitrure de silicium.

La puce électronique, et donc son amorce 1 peut être divisée en plusieurs zones spatiales correspondant chacune à des emplacements où des composants de la puce sont destinés à être réalisés. Dans l'exemple illustré, une première zone A de la puce électronique correspond aux premières cellules élémentaires à réaliser, une deuxième zone B correspond aux secondes cellules élémentaires à réaliser, et une troisième zone C correspond à des connexions entre les niveaux de la puce électronique. Par souci de simplification, la première zone A est montrée adjacente à la deuxième zone B. D'autres zones pourraient cependant les séparer. De plus, il pourrait y avoir plusieurs premières zones A et plusieurs deuxièmes zones B, chacune destinée à recevoir une matrice mémoire. La troisième zone C est présente pour montrer un exemple de compatibilité du procédé de fabrication avec la réalisation d'autres composants, mais cette troisième zone C et ses caractéristiques sont optionnelles, et seront parfois omises.

Les contacts métalliques 2a, 2b, 2c sont régulièrement répartis dans la première couche d'isolation 4 et traversent à la fois la première couche d'isolation 4 et la première couche de passivation 6. Les contacts métalliques 2a, 2b, 2c affleurent à la surface de la première couche d'isolation 4. Afin de simplifier, seuls deux contacts par zone sont illustrés dans les coupes apparaissant dans les figures, mais il est bien entendu qu'en réalité beaucoup plus (parfois des centaines et plus généralement des milliers) de contacts métalliques 2a, 2b sont alignés au moins pour la première zone A et la deuxième zone B, puisque chaque matrice de cellules élémentaires comporte typiquement plusieurs milliers ou millions de cellules élémentaires.

Sur l'amorce 1 de la puce électronique, et notamment sur la première couche d'isolation 4, sont réalisés des connecteurs de chauffe inférieurs traversant une couche de passivation, de préférence en nitrure de silicium, pour connecter au moins les contacts métalliques 2a de la première zone A, et dans ce mode de réalisation connectant également les contacts métalliques 2b de la deuxième zone B et les contacts métalliques 2c de la troisième zone C. Ces connecteurs de chauffe inférieurs serviront à faire circuler le courant de chauffe et à s'échauffer par effet Joule.

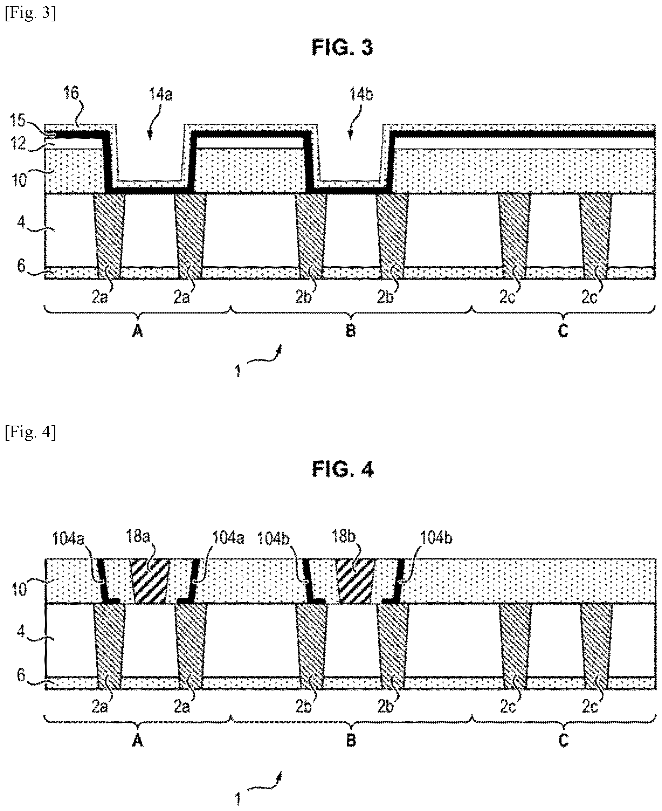

Pour ce faire, comme illustré sur la figure 3, une couche intermédiaire 10, de préférence en nitrure de silicium, est disposée à la surface de la première couche d'isolation 4, recouvrant les contacts métalliques 2a, 2b, 2c qui y affleurent. Une seconde couche d'isolation 12, typiquement en dioxyde de silicium, est ensuite déposée sur la couche intermédiaire 10. Au moyen d'un masque initial de gravure présentant une ouverture au niveau de la première zone A et une ouverture au niveau de la deuxième zone B, des sillons 14a, 14b sont ménagés par gravure jusqu'à atteindre la première couche d'isolation 4 et dégager au moins partiellement chaque contact métallique 2a, 2b de la première zone A et de la deuxième zone B. Dans l'exemple illustré, chaque sillon 14a, 14b chevauche deux contacts métalliques 2a, 2b, et permet donc de dégager deux contacts métalliques 2a, 2b à la fois. De préférence, les parois des sillons 14a, 14b sont au-dessus des contacts métalliques 2a, 2b de la première zone A et de la deuxième zone B.

Une première couche conductrice 15 est ensuite déposée, par exemple en nitrure de titane ou en nitrure de titane-silicium. Cette première couche conductrice 15 est destinée à former des conducteurs de chauffe inférieurs. Comme les autres couches, cette première couche conductrice 15 recouvre l'ensemble de l'amorce 1, et recouvre donc la seconde couche d'isolation 12 pour les zones non gravées, pour les zones gravées recouvre la première couche d'isolation 4 à la surface de laquelle effleurent les contacts métalliques 2a, 2b de la première zone A et de la deuxième zone B, dans les sillons 14a, 14b. Sur cette première couche conductrice 15 peut être déposée une deuxième couche de passivation 16, par exemple en nitrure de silicium. Lorsque les parois des sillons 14a, 14b sont au-dessus des contacts métalliques 2a, 2b, la couche conductrice 15 qui les recouvre s'élève également au-dessus des contacts métalliques 2a, 2b.

Il est ensuite procédé à la formation d'espaceurs 18a, 18b dans les sillons 14a, 14b, entre des connecteurs de chauffe inférieurs 104a, 104b adjacents formés à partir de la première couche conductrice 15, au droit de deux contacts métalliques 2a, 2b adjacents. Pour ce faire, il est par exemple procédé à une gravure retirant la deuxième couche de passivation 16 au moins dans les dans les sillons 14a, 14b. Un dépôt supplémentaire de nitrure de silicium peut avoir lieu, puis une autre gravure au moins dans les dans les sillons 14a, 14b. Ainsi, la couche conductrice 15 à la surface de la première couche d'isolation 4 entre deux contacts métalliques 2a, 2b adjacents est retirée. Des espaceurs 18a, 18b isolants, par exemple en dioxyde de silicium SiO2, peuvent être ensuite disposés pour remplir les espaces ainsi dégagés des sillons 14a, 14b.

Les parties au-dessus de la couche intermédiaire 10 sont ensuite retirées pour aplanir l'amorce 1, par exemple par planarisation mécano-chimique, au niveau de la surface de couche intermédiaire 10. Alors que la seconde couche d'isolation 12 est ainsi entièrement retirée, les parties de la couche conductrice 15 et de la deuxième couche de passivation 16 qui pénètrent dans les sillons 14a, 14b en-deçà de la surface de la couche intermédiaire 10, sont conservées, de même que les espaceurs 18a, 18b. On obtient alors l'amorce 1 de la figure 4. Les parties conservées de la couche conductrice 15 forment les connecteurs de chauffe inférieurs 104a, 104b, et les espaceurs 18a, 18b sont interposés entre des connecteurs de chauffe inférieurs 104a, 104b adjacents.

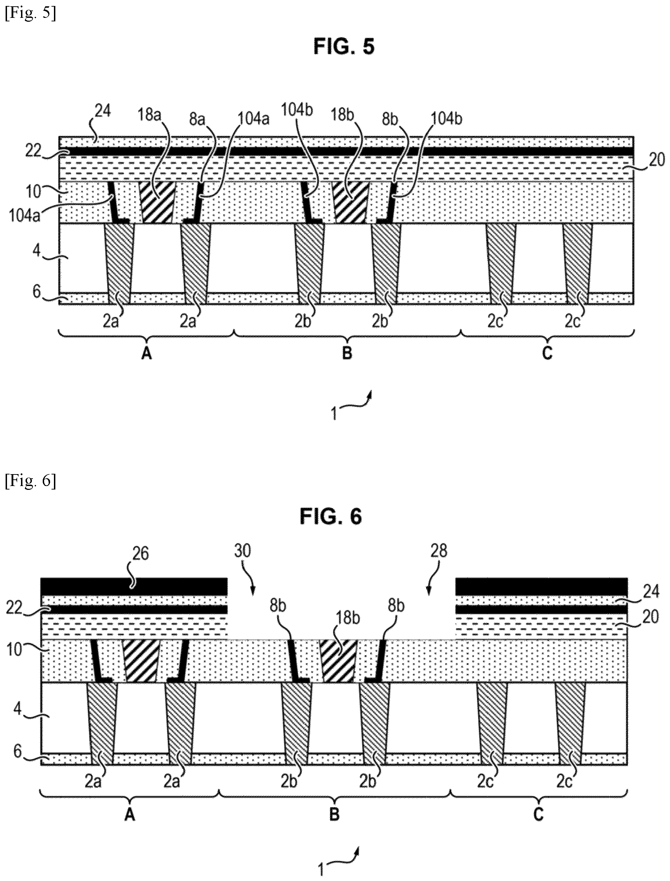

Comme illustré sur la figure 5, une couche du premier matériau 20 est déposée sur la couche intermédiaire 10, au contact des connecteurs de chauffe inférieurs 104a, 104b de la première zone A et de la deuxième zone B. Le premier matériau 20 est destiné à former la partie des éléments de stockage d'une première matrice de cellules élémentaires, dont l'état est fonction du bit stocké. Plus précisément, un volume du premier matériau 20 présente soit un état cristallin soit un état amorphe en fonction du bit stocké dans l'élément de stockage dont il fait partie. Le premier matériau présente donc des caractéristiques appropriées pour former des éléments de mémoires à changement de phase, et présentent en particulier des propriétés de conservation de son état cristallin ou amorphe suffisante pour assurer à l'élément de stockage une rétention à long terme (plusieurs années) du bit qui y est stocké. De préférence, le premier matériau est un chalcogénure, et de préférence encore est un composé ternaire de chalcogénure. En particulier, le premier matériau peut être en germanium-antimoine-tellure (GeSbTe), avec une teneur majoritaire en germanium, supérieure à 60%, et de préférence supérieure à 70%, et de préférence encore d'au moins 80%.

Comme illustré sur la figure 5, au-dessus de la couche du premier matériau 20, une seconde couche conductrice 22 est déposée, par exemple en nitrure de titane ou en nitrure de titane-silicium. Cette seconde couche conductrice 22 est destinée à former des connecteurs conducteurs supérieurs 106a pour chaque première cellule élémentaire 100a, destinés à permettre la circulation du courant à travers la première cellule élémentaire 100a. Une troisième couche de passivation 24, par exemple en nitrure de silicium, peut être déposée sur la seconde couche conductrice 22.

Comme illustré sur la figure 6, un premier masque de gravure 26 est alors mis en place. Ce premier masque de gravure 26 présente une ouverture 28 au droit de la deuxième zone B, mais couvre les autres zones A, C. Il est ensuite procédé à la gravure, au niveau de la deuxième zone B, de la seconde couche conductrice 22 et de la couche de premier matériau 20, ainsi que de la couche de passivation 24, pour réaliser un espace gravé 30. L'espace gravé 30 découvre donc la surface de la couche intermédiaire 10, au niveau de la deuxième zone B, à la surface de laquelle effleure les connecteurs de chauffe inférieurs 104b de la deuxième zone B.

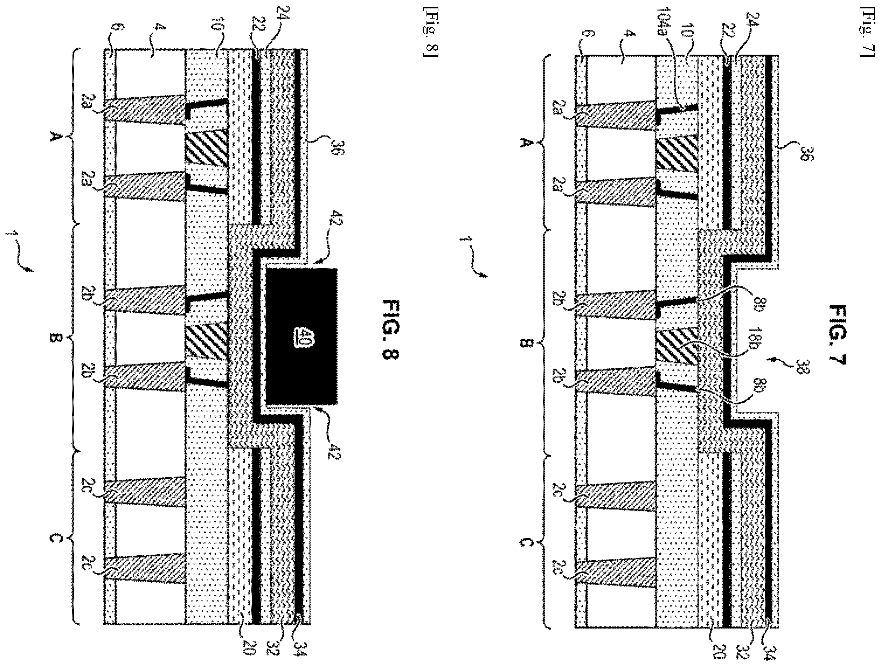

Comme illustré sur la figure 7, une couche de second matériau 32 est ensuite déposée, à la fois sur les parties gravées (dans l'espace gravé 30) correspondant à la deuxième zone B) et les parties non gravées, correspondant au moins à la première zone A, et à la troisième zone C. Le second matériau 32, recouvrant le fond de l'espace gravé 30, de la couche intermédiaire 10, est donc, dans la deuxième zone B, au contact de connecteurs de chauffe inférieurs 104b. Le second matériau 32 est différent du premier matériau 20 et est destiné à former la partie des éléments de stockage d'une deuxième matrice de cellules élémentaires, dont l'état est fonction du bit stocké. Plus précisément, un volume du second matériau 32 présente soit un état cristallin soit un état amorphe en fonction du bit stocké dans l'élément de stockage dont il fait partie. Le second matériau présente donc des caractéristiques appropriées pour former des éléments de mémoires à changement de phase, et présentent en particulier des propriétés de changement de son état cristallin ou amorphe qui permettent aux secondes cellules élémentaires de présenter une vitesse d'accès (lecture et/ou écriture) plus rapide que celle des premières cellules élémentaires. Pour ce faire, le second matériau présente une température de fusion inférieure à celle du premier matériau d'au moins 50°C, et de préférence inférieure à celle du premier matériau d'au moins 80°C, et de préférence encore inférieure à celle du premier matériau d'au moins 120°C. La température de fusion de chaque matériau peut par exemple être déterminée par la méthode dite "Rs(T)", dans laquelle la résistance d'un échantillon de matériau est mesurée en fonction de la température. La température de fusion correspond à la température à laquelle est observée une chute brutale de la résistance, celle-ci étant attribuée à la fusion du matériau testé.

De préférence, le second matériau est un chalcogénure, et de préférence encore est un composé ternaire de chalcogénure. En particulier, le second matériau peut être en germanium-antimoine-tellure (GeSbTe), avec une teneur majoritaire en antimoine, supérieure à 60%, et de préférence supérieure à 70%, et de préférence encore d'au moins 80%.

Une troisième couche conductrice 34, destinée à former des seconds conducteurs supérieurs 106b, pour les secondes cellules élémentaires 100b, est ensuite déposée sur la couche de second matériau 32. Une cinquième couche de passivation 36, par exemple en nitrure de silicium, peut être déposée sur la troisième couche conductrice 34. Au niveau de l'espace gravé 30, la couche de second matériau 32, la troisième couche conductrice 34, et la cinquième couche de passivation 36 laissent un enfoncement 38 par rapport à leurs niveaux au-dessus de la première zone A et de la troisième zone C.

Comme illustré sur la figure 8, un second masque de gravure 40 est ensuite mis en place. Ce second masque de gravure 40 couvre un espace de la deuxième zone B qui correspond à l'enfoncement 38 qui reste de l'espace gravé 30 après le dépôt de la couche de second matériau 32, la troisième couche conductrice 34, et la cinquième couche de passivation 36. En revanche, le second masque de gravure 40 laisse dégagées la première zone A et la troisième zone C. Il est à noter qu'en raison des nécessaires tolérances de dimension, des jeux 42 sont présents entre la partie couvrante du masque de gravure 40 et les parois de l'enfoncement 38 recouvertes par la cinquième couche de passivation 36.

Il est ensuite procédé au retrait du second matériau de la première zone A, et de la troisième zone C. Ce retrait est de préférence effectué en procédant à une gravure dans les parties ouvertes du second masque de gravure 40, et notamment au niveau de la première zone A. Cette gravure permet de retirer le second matériau de la première zone A, et de la troisième zone C. La gravure est effectuée jusqu'à dégager la surface de la troisième couche de passivation 24 au niveau de la première zone A et de la troisième zone C. Alternativement, il est possible de retirer le second matériau de la première zone A et de la troisième zone C par planarisation mécano-chimique (CMP).

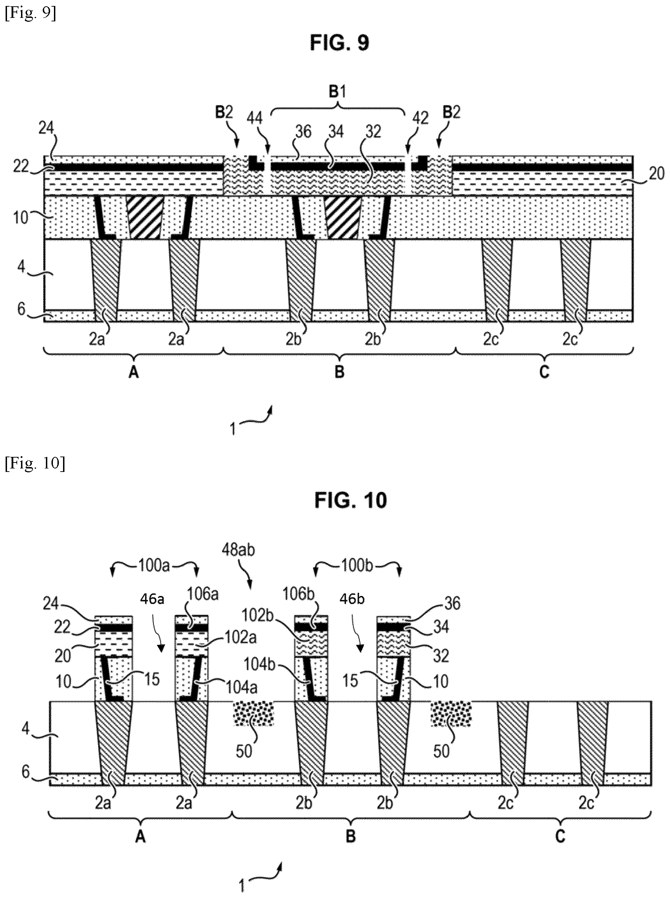

Comme illustré sur la figure9, l'amorce 1 présente alors une surface plane, formée au niveau de la première zone A et de la troisième zone C par la troisième couche de passivation 24 au-dessus de la seconde couche conductrice 22 et du premier matériau 20. Au niveau de la deuxième zone B, on distingue une partie centrale B1 de cette deuxième zone B, qui a été protégée par la partie couvrante du second masque de gravure 40, et une partie périphérique B2 de cette deuxième zone B, qui n'était pas protégée par la partie couvrante du second masque de gravure 40. Dans la partie centrale B1 de la deuxième zone B, la surface de l'amorce 1 est formée par la cinquième couche de passivation 36 qui était sous la partie couvrante du second masque de gravure 40, avec en-dessous la troisième couche conductrice 34, destinée à former des seconds conducteurs supérieurs 106b, et le second matériau 32.

La partie périphérique B2 de la deuxième zone B, non couverte par la gravure, correspond aux parois de l'enfoncement 38, c'est-à-dire aux couches de la cinquième couche de passivation 36, de la troisième couche conductrice 34 et du second matériau, qui ont été gravées et donc nivelées avec la troisième couche de passivation 24. En raison des jeux 42 qui étaient présents entre la partie couvrante du masque de gravure 40 et les parois de l'enfoncement 38 recouvertes par la cinquième couche de passivation 36, la partie périphérique B2 comprend également, à sa limite avec la partie centrale B1, des évidements 44 résultant de l'action de la gravure dans les jeux 42. Ces évidements 44 pénètrent la cinquième couche de passivation 36, la troisième couche conductrice 34, et peuvent pénétrer le second matériau 32 jusqu'à la couche intermédiaire 10 (en fonction des épaisseurs des couches retirés par la gravure et de leur nature).

Il est ensuite procédé à une gravure de séparation des premières cellules élémentaires et des secondes cellules élémentaires. Cette gravure comprend la formation de sillons de séparation 46a, 46b parallèles (par exemple au moyen d'un masque de résine) séparant les lignes de cellules élémentaires de chaque matrice jusqu'à la première couche d'isolation 4. La gravure de séparation entraîne donc le retrait des espaceurs 18a, 18b et des couches au-dessus de ces espaceurs 18a, 18b. En revanche, les couches au-dessus des connecteurs de chauffe inférieurs 104a, 104b, qui prolongent les contacts métalliques 2a, 2b de la première zone A et de la deuxième zone B, sont conservées. Ainsi que visible sur la figure 10, une coupe d'une ligne de cellule élémentaire 100a, 100b présente donc, au-dessus d'un contact métallique 2a, 2b, un volume 102a, 102b de matériau à changement de phase (premier matériau 20 pour la première zone A et second matériau 32 pour la deuxième zone B) encadré par un connecteur de chauffe inférieur 104a, 104b (issu de la première couche conductrice 15) et par un conducteur supérieur 106a, 106b (issu de la seconde couche conductrice 22 pour la première zone A et de la troisième couche conductrice 34 pour la deuxième zone B).

La gravure de séparation comprend également la gravure des interfaces 48ab entre les zones A, B. Suite à cette gravure de séparation, les lignes de cellules élémentaires sont isolées les unes des autres. La gravure de séparation peut également comprendre le retrait des matières sur la première couche d'isolation 4, en dehors des zones destinées à former les matrices de mémoire à changement de phase, comme par exemple pour la troisième zone C.

Il est à noter qu'en raison de la présence des évidements 44 dans la partie périphérique B2 de la deuxième zone B qui a été gravée par la gravure de séparation, la gravure de séparation peut entraîner des dégradations localisées 50 de la première couche d'isolation 4, face aux évidements 44. Toutefois, dans la mesure où les jeux 42, et donc les évidements 44 en résultant, sont minimes puisque la partie couvrante du masque de gravure 40 est choisie pour épouser au mieux les parois de l'enfoncement 38, ces dégradations localisées 50 s'étendent en général sur une largeur de moins de 100 nm à la surface de la première couche d'isolation 4.

Les matrices de cellules élémentaires 100a, 100b sont ensuite finalisées (figure 1). Les contacts métalliques 2c de la troisième zone C traversant la première couche d'isolation 4 peuvent être prolongés par des vias 110, typiquement en métal tel que du tungstène. Une couche d'isolation 51, par exemple en dioxyde de silicium, peut être mise en place pour combler les interstices entre les cellules élémentaires 100a, 100b. Une couche nitrure 52 peut être disposée sur la couche d'isolation 51. La couche nitrure 52 peut être surmontée d'une couche diélectrique inter-métal (ou IMD pour "Inter Métal Dielectric"), généralement d'un oxyde. Il est enfin possible de procéder à la métallisation, pour former des lignes conductrices 108a, 108b, typiquement en métal tel que le cuivre, pour connecter chaque cellule élémentaire 100a, 100b.

Le fonctionnement d'une cellule élémentaire 100a, 100b est le suivant. Un courant de chauffe circulant entre le contact métallique 2a, 2b et la ligne conductrice 108a 108b, via le connecteur de chauffe inférieur 104a, 104b, le volume 102a de premier matériau 20 ou le volume 102b de second matériau 60, et le conducteur supérieur 106a, 106b, provoque par effet joule l'échauffement au moins du connecteur de chauffe inférieur 104a, 104b et éventuellement du conducteur supérieur 106a, 106b. La température du volume 102a, 102b de matériau à changement de phase augmente. Pour stocker un bit par un état amorphe du volume 102a, 102b de matériau à changement de phase, la température est augmentée jusqu'à dépasser le point de fusion de ce matériau à changement de phase, puis par un refroidissement rapide du volume 102a, 102b de matériau à changement de phase, celui-ci prend un état amorphe. Pour stocker un bit par un état cristallin du volume 102a, 102b de matériau à changement de phase, la température est augmentée jusqu'à permettre la cristallisation du matériau à changement de phase. Le volume 102a, 102b de matériau à changement de phase prend alors un état cristallin. La lecture est permise par la différence de conductivité électrique entre l'état cristallin et l'état amorphe.

### Second procédé de fabrication

En référence aux figures 12 à 18, il va maintenant être décrit un autre procédé de fabrication qui permet d'obtenir la puce électronique de la figure 11. Comme précédemment, une première étape du procédé comprend la fourniture d'une amorce 1 de puce électronique issue d'une fabrication initiale (plus connu sous le terme anglais de "Front-end-of-Line" ou FEOL), qui est illustrée par la figure 12. Afin de simplifier la description, il ne sera traité ici que les parties de la fabrication correspondant à la fabrication de la première matrice de cellules élémentaires et de la seconde matrice de cellules élémentaires formant deux types de mémoire à changement de phase. Les autres parties (processeurs, autres mémoires, etc.) ne sont ni représentées dans les figures, ni détaillées ici, bien qu'elles soient également présentes lors de la fabrication.

Dans le cas présent, l'amorce 1 présente donc à la surface d'un substrat les dispositifs tels que les transistors et les sélecteurs qui forment une partie de la logique des mémoires. Cette partie n'est pas représentée sur les figures, dans la mesure où il s'agit d'une partie connue de l'homme du métier, non impactée par l'invention. De préférence, le substrat formé de silicium sur isolant. L'amorce 1 comprend une pluralité de contacts métalliques 2a, 2b, 2c (par exemple en tungstène) traversant une première couche d'isolation 4, par exemple en dioxyde de silicium, qui peut être formée à la surface d'une couche de passivation 6, par exemple en nitrure de silicium.

La puce électronique, et donc son amorce 1, peut être divisée en plusieurs zones spatiales correspondant chacune à des emplacements où des composants de la puce sont destinés à être réalisés. Dans l'exemple illustré, une première zone A de la puce électronique correspond aux premières cellules élémentaires à réaliser, une deuxième zone B correspond aux secondes cellules élémentaires à réaliser, et une troisième zone C correspond à des connexions entre les niveaux de la puce électronique. Par souci de simplification, la première zone A est montrée adjacente à la deuxième zone B. D'autres zones pourraient cependant les séparer. De plus, il pourrait y avoir plusieurs premières zones A et plusieurs deuxièmes zones B, chacune destinée à recevoir une matrice mémoire. La troisième zone C est présente pour montrer un exemple de compatibilité du procédé de fabrication avec la réalisation d'autres composants, mais cette troisième zone C et ses caractéristiques sont optionnelles, et seront parfois omises dans la description.

Les contacts métalliques 2a, 2b, 2c sont régulièrement répartis dans la première couche d'isolation 4 et traversent à la fois la première couche d'isolation 4 et la première couche de passivation 6. Les contacts métalliques 2a, 2b, 2c affleurent à la surface de la première couche d'isolation 4. Afin de simplifier, seuls deux contacts métalliques 2a, 2b, 2c par zone sont illustrés dans les coupes apparaissant dans les figures, mais il est bien entendu qu'en réalité beaucoup plus (parfois des centaines et plus généralement des milliers) de contacts métalliques 2a, 2b sont alignés au moins pour la première zone A et la deuxième zone B, puisque chaque matrice de cellules élémentaires comporte typiquement plusieurs milliers ou millions de cellules élémentaires.

Sur l'amorce 1 de la puce électronique, et notamment sur la première couche d'isolation 4, sont réalisés des connecteurs de chauffe inférieurs 104a traversant une couche de passivation, de préférence en nitrure de silicium, pour connecter au moins les contacts métalliques 2a de la première zone A, mais pas les contacts métalliques 2b de la deuxième zone B.

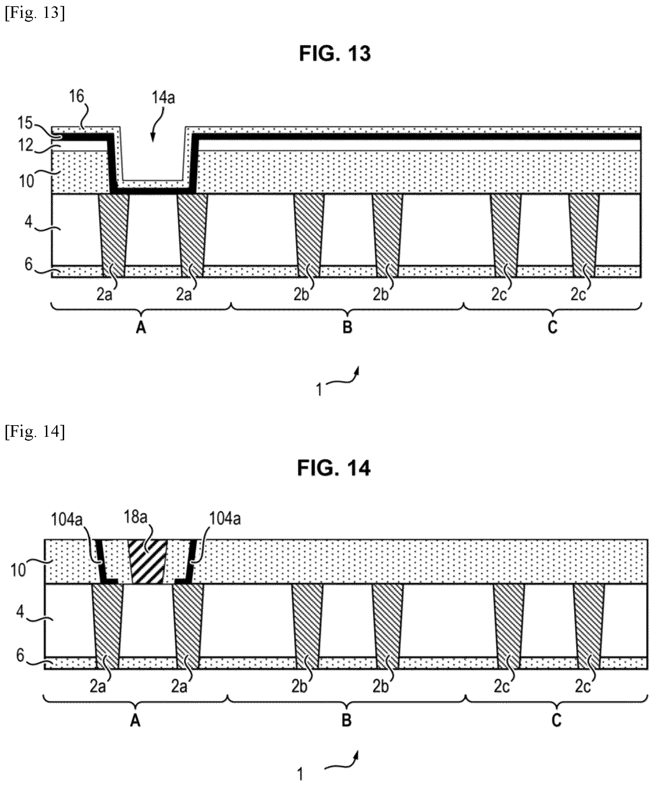

Pour ce faire, comme illustré sur la figure 13, une couche intermédiaire 10, de préférence en nitrure de silicium, est disposée à la surface de la première couche d'isolation 4, recouvrant les contacts métalliques 2a, 2b, 2c qui y affleurent. Une seconde couche d'isolation 12, typiquement en dioxyde de silicium, est ensuite déposée sur la couche intermédiaire 10. Au moyen d'un masque initial de gravure présentant une ouverture au niveau de la première zone A, des sillons 14a sont ménagés par gravure jusqu'à atteindre la première couche d'isolation 4 et dégager au moins partiellement chaque contact métallique 2a, de la première zone A. En revanche, les contacts métalliques 2b de la deuxième zone B ne sont pas dégagés. Dans l'exemple illustré, chaque sillon 14a chevauche deux contacts métalliques 2a, et permet donc de dégager deux contacts métalliques 2a à la fois. De préférence, les parois des sillons 14a sont au-dessus des contacts métalliques 2a de la première zone A.

Une première couche conductrice 15 est ensuite déposée, par exemple en nitrure de titane ou en nitrure de titane-silicium. Cette première couche conductrice 15 est destinée à former des conducteurs de chauffe inférieurs 104a pour les premières cellules élémentaires 100a. Comme les autres couches, cette première couche conductrice 15 recouvre l'ensemble de l'amorce 1, et recouvre donc la seconde couche d'isolation 12 pour les zones non gravées (deuxième zone A et troisième zone C), et pour les zones gravées (première zone A) recouvre la première couche d'isolation 4 à la surface de laquelle effleurent les contacts métalliques 2a de la première zone A, dans les sillons 14a. Sur cette première couche conductrice 15 peut être déposée une deuxième couche de passivation 16, par exemple en nitrure de silicium. Lorsque les parois des sillons 14a sont au-dessus des contacts métalliques 2a, la couche conductrice 15 qui les recouvre s'élève également au-dessus des contacts métalliques 2a de la première zone A.

Comme précédemment expliqué en référence aux figures 3 et 4, des espaceurs 18a isolants sont formés dans les sillons 14a, entre des connecteurs de chauffe inférieur 104a adjacents formés à partir de la première couche conductrice 15, au droit de deux contacts métalliques 2a adjacents. Toutefois, seule la première zone A est ici concernée. Pour ce faire, il est par exemple procédé à une gravure retirant la deuxième couche de passivation 16 au moins dans les dans les sillons 14a. Un dépôt supplémentaire de nitrure de silicium peut avoir lieu, puis une autre gravure au moins dans les dans les sillons 14a. Ainsi, la couche conductrice 15 à la surface de la première couche d'isolation 4 entre deux contacts métalliques 2a adjacents est retirée. Des espaceurs 18a isolants, par exemple en dioxyde de silicium SiO2, peuvent être ensuite disposés pour remplir les espaces ainsi dégagés des sillons 14a.

Les parties au-dessus de la couche intermédiaire 10 sont ensuite retirée pour aplanir l'amorce 1, par exemple par planarisation mécano-chimique, au niveau de la surface de la couche intermédiaire 10. Alors que la seconde couche d'isolation 12 est ainsi entièrement retirée, les parties de la couche conductrice 15 et de la deuxième couche de passivation 16 qui pénètrent dans les sillons 14a en-deçà de la surface de la première couche d'isolation 4, sont conservées, de même que les espaceurs 18a. On obtient alors l'amorce 1 de la figure 14. Les parties conservées de la couche conductrice 15 sont destinées à former les connecteurs de chauffe inférieurs 104a, et les espaceurs 18a sont interposés entre des connecteurs de chauffe inférieurs 104a adjacents de la première zone A.

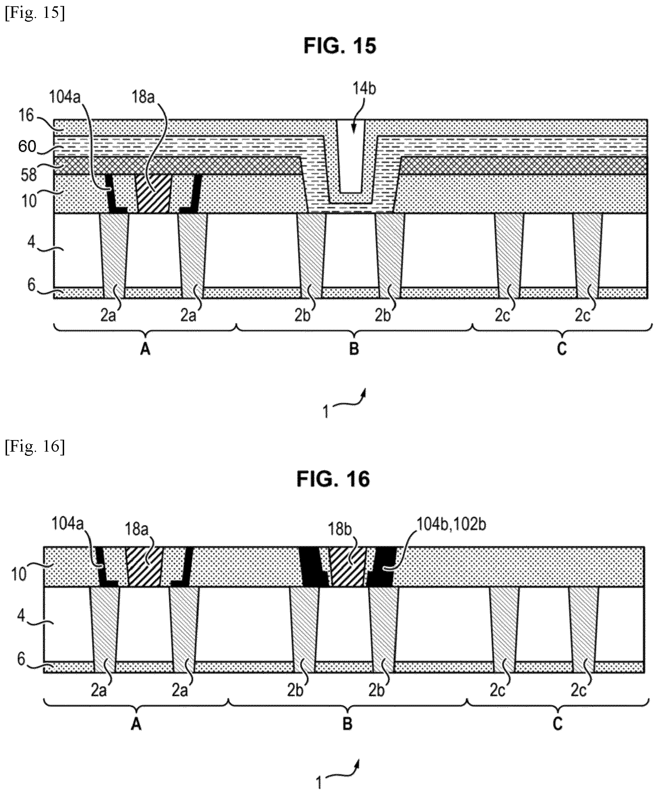

Comme illustré sur la figure 15, une couche d'isolation 58, de préférence en oxyde de silicium, est disposée à la surface de la couche intermédiaire 10. Au moyen d'un premier masque de gravure présentant une ouverture découvrant la deuxième zone B, des sillons 14b sont ménagés par gravure jusqu'à atteindre la première couche d'isolation 4 et dégager au moins partiellement chaque contact métallique 2b de la deuxième zone B. Cette étape est similaire à celle de la figure 6, sauf en ce que la gravure atteint ici les contacts métalliques 2b de la deuxième zone B. En revanche, les contacts métalliques 2a de la première zone A ne sont pas dégagés. Dans l'exemple illustré, chaque sillon 14b chevauche deux contacts métalliques 2b, et permet donc de dégager deux contacts métalliques 2b à la fois. De préférence, les parois des sillons 14b sont au-dessus des contacts métalliques 2b de la deuxième zone B.

Une couche de second matériau 60 est ensuite déposée, à la fois dans les sillons 14b correspondant à la deuxième zone B et sur les parties non gravées de la couche d'isolation 58, correspondant au moins à la première zone A, et à la troisième zone C. Le second matériau 60, recouvrant le fond des sillons 14b, est donc en contact avec la première couche d'isolation 4 à la surface de laquelle effleurent les contacts métalliques 2b de la première zone B. Lorsque les parois des sillons 14b sont au-dessus des contacts métalliques 2b de la deuxième zone B, la couche de second matériau 60 qui les recouvre s'élève également au-dessus de ces contacts métalliques 2b. Une deuxième couche de passivation 16, par exemple en nitrure de silicium, peut être déposée sur la couche de second matériau 60.

Le second matériau 60 est destiné à former la partie des éléments de stockage d'une deuxième matrice de cellules élémentaires, dont l'état est fonction du bit stocké. Plus précisément, un volume du second matériau 60 présente soit un état cristallin soit un état amorphe en fonction du bit stocké dans l'élément de stockage dont il fait partie. Le second matériau 60 présente donc des caractéristiques appropriées pour former des éléments de mémoires à changement de phase. De préférence, le second matériau est un chalcogénure, et de préférence encore est un composé ternaire de chalcogénure. En particulier, le second matériau peut être en germanium-antimoine-tellure (GeSbTe), avec une teneur majoritaire en antimoine, supérieure à 60%, et de préférence supérieure à 70%, et de préférence encore d'au moins 80%.

Il est ensuite procédé à une gravure dans les sillons 14b, retirant la couche de passivation 58 et la couche de second matériau 60 à la surface de la première couche d'isolation 4 entre deux contacts métalliques 2b adjacents. Des espaceurs 18b isolants, par exemple en dioxyde de silicium SiO2, peuvent être ensuite disposés dans les espaces ainsi dégagés des sillons 14b. Les sillons 14b peuvent ensuite être comblés avec un isolant, par exemple du dioxyde de silicium.

Il est ensuite procédé au retrait du second matériau de la première zone A pour dégager la couche intermédiaire 10. Les parties au-dessus de la couche intermédiaire 10 sont donc retirée pour aplanir l'amorce 1, par exemple par planarisation mécano-chimique, au niveau de la surface de la couche intermédiaire 10. Alors que la couche d'isolation 58 est ainsi entièrement retirée, les parties de la couche de second matériau 60 et de la deuxième couche de passivation 16 qui pénètrent dans les sillons 14b en-deçà de la surface de la couche intermédiaire 10, sont conservées, de même que les espaceurs 18b. On obtient alors l'amorce 1 de la figure 16. Les parties conservées du second matériau 60 forment à la fois les connecteurs de chauffe inférieurs 104b et les volume de matériau à changement de phase présentant soit un état cristallin soit un état amorphe en fonction du bit stocké.

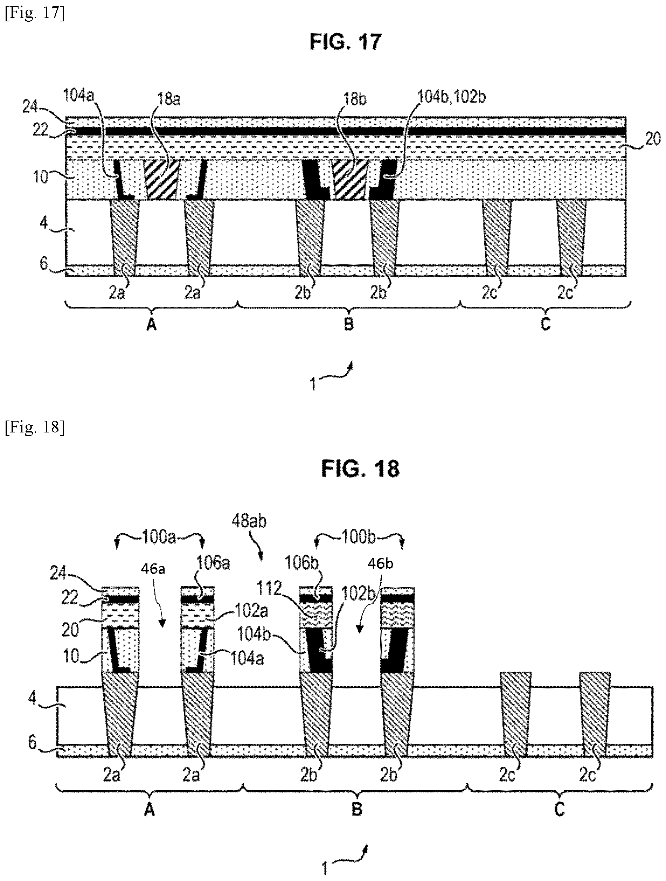

Comme illustré sur la figure 17, une couche du premier matériau 20 à changement de phase est déposée sur la couche intermédiaire 10 au niveau de la première zone A et de la deuxième zone B. La couche de premier matériau 20 est au contact des connecteurs de chauffe inférieurs 104a, 104b de la première zone A et de la deuxième zone B. Le premier matériau est destiné à former la partie des éléments de stockage d'une première matrice de cellules élémentaires, dont l'état est fonction du bit stocké. Plus précisément, un volume du premier matériau présente soit un état cristallin soit un état amorphe en fonction du bit stocké dans l'élément de stockage dont il fait partie. Le premier matériau présente donc des caractéristiques appropriées pour former des éléments de mémoires à changement de phase, et présentent en particulier des propriétés de conservation de son état cristallin ou amorphe suffisante pour assurer à l'élément de stockage une rétention à long terme (plusieurs années) du bit qui y est stocké. Notamment, cette rétention est meilleure que celle des seconds éléments de stockage formés par le second matériau. Pour ce faire, le premier matériau présente une température de fusion supérieure à celle du second matériau d'au moins 50°C, et de préférence supérieure à celle du second matériau d'au moins 80°C, et de préférence encore supérieure à celle du second matériau d'au moins 120°C. La température de fusion de chaque matériau peut par exemple être déterminée par la méthode dite "Rs(T)", dans laquelle la résistance d'un échantillon de matériau est mesurée en fonction de la température. La température de fusion correspond à la température à laquelle est observée une chute brutale de la résistance, celle-ci étant attribuée à la fusion du matériau testé.

De préférence, le premier matériau est un chalcogénure, et de préférence encore est un composé ternaire de chalcogénure. En particulier, le premier matériau peut être en germanium-antimoine-tellure (GeSbTe), avec une teneur majoritaire en germanium, supérieure à 60%, et de préférence supérieure à 70%, et de préférence encore d'au moins 80%.

Comme illustré sur la figure 17, au-dessus de la couche du premier matériau 20, une seconde couche conductrice 22 est déposée, par exemple en nitrure de titane ou en nitrure de titane-silicium. Cette seconde couche conductrice 22 est destinée à former des conducteurs supérieurs 106a, 106b pour les éléments de stockage de la première zone A et de la deuxième zone B. Une troisième couche de passivation 24, par exemple en nitrure de silicium, peut être déposée sur la seconde couche conductrice 22.

Il est ensuite procédé à une gravure de séparation des premières cellules élémentaires 100a et des secondes cellules élémentaires 100b. Cette gravure comprend la formation de sillons de séparation 46a, 46b parallèles (par exemple par photolithographie) séparant les lignes de cellules élémentaires 100a, 100b de chaque matrice jusqu'à la première couche d'isolation 4. La gravure de séparation entraîne donc le retrait des espaceurs 18a, 18b et des couches au-dessus de ces espaceurs 18a, 18b. En revanche, les couches au-dessus des connecteurs de chauffe inférieurs 104a, 104b, qui prolongent les contacts métalliques 2a, 2b de la première zone A et de la deuxième zone B, sont conservées.

Ainsi que visible sur la figure 18, une coupe d'une première cellule élémentaire 100a, présente donc au-dessus d'un contact métallique 2a, un volume 102a de premier matériau 20 à changement de phase encadré par un connecteur de chauffe inférieur 104a (issu de la première couche conductrice 15) et par un conducteur supérieur 106a (issu de la seconde couche conductrice 22). Une coupe d'une seconde cellule élémentaire 100b présente au-dessus d'un contact métallique 2b, un volume 102b de second matériau 60 à changement de phase formant également un connecteur de chauffe inférieur 104b. Au-dessus de ce volume 102b de second matériau 60 à changement de phase se trouve un volume 112b de premier matériau 20 à changement de phase, et un conducteur supérieur 106b (issu de la seconde couche conductrice 22).

La gravure de séparation comprend également la gravure des interfaces 48ab entre les zones A, B. Suite à cette gravure de séparation, les lignes de cellules élémentaires 100a, 100b sont isolées les unes des autres. La gravure de séparation peut également comprendre le retrait des matières sur la première couche d'isolation 4, en dehors des zones destinées à former les matrices de mémoire à changement de phase, comme par exemple pour la troisième zone C.

Les matrices de cellules élémentaires 100a, 100b sont ensuite finalisées (figure 11). Les contacts métalliques 2c de la troisième zone C traversant la première couche d'isolation 4 peuvent être prolongés par des vias 110, typiquement en métal tel que du tungstène. Une couche d'isolation 51, par exemple en dioxyde de silicium, peut être mise en place pour combler les interstices entre les cellules élémentaires 100a, 100b. Une couche nitrure 52 peut être disposée sur la couche d'isolation 51. La couche nitrure 52 peut être surmontée d'une couche diélectrique inter-métal (ou IMD pour "Inter Métal Dielectric"), généralement d'un oxyde. Il est enfin possible de procéder à la métallisation, pour former des lignes conductrices 108a, 108b, typiquement en métal tel que le cuivre, pour connecter chaque cellule élémentaire 100a, 100b.

Le fonctionnement d'une première cellule élémentaire 100a est le suivant. Un courant circulant entre le contact métallique 2a et la ligne conductrice 108a, via le connecteur de chauffe inférieur 104a, le volume 102a de premier matériau 20 et le conducteur supérieur 106a, provoque par effet joule l'échauffement au moins du connecteur de chauffe inférieur 104a, et éventuellement du conducteur supérieur 106a. La température du volume 102a de premier matériau 20 augmente. Pour stocker un bit par un état amorphe du volume 102a de premier matériau 20, la température est augmentée jusqu'à dépasser le point de fusion de ce premier matériau 20, puis par un refroidissement rapide du volume 102a de premier matériau 20, celui-ci prend un état amorphe. Pour stocker un bit par un état cristallin du volume 102a de premier matériau 20, la température est augmentée jusqu'à permettre la cristallisation du premier matériau, mais reste inférieure au point de fusion de ce premier matériau 20. Le volume 102a de premier matériau 20 prend alors un état cristallin. La lecture est permise par la différence de conductivité entre l'état cristallin et l'état amorphe.

Le fonctionnement d'une seconde cellule élémentaire 100b est le suivant. Un courant circulant entre le contact métallique 2b et la ligne conductrice 108b, via le volume 102b de second matériau 60, le volume 112 de premier matériau 20 et le conducteur supérieur 106b, provoque par effet joule l'échauffement du volume 102b de second matériau 60, et éventuellement du conducteur supérieur 106b. La température du volume 102b de second matériau 60 augmente. Pour stocker un bit par un état amorphe du volume 102b de premier matériau 60, la température est augmentée jusqu'à dépasser le point de fusion de ce second matériau 60, puis par un refroidissement rapide du volume 102b de second matériau 60, celui-ci prend un état amorphe. De préférence, la température ne dépasse par le point de fusion du premier matériau 20 (qui est supérieure à celle du second matériau 60) . Pour stocker un bit par un état cristallin du volume 102b de second matériau 60, la température est augmentée jusqu'à permettre la cristallisation du second matériau, mais reste inférieure au point de fusion de ce second matériau 60. Le volume 102b de second matériau 60 prend alors un état cristallin. La lecture est permise par la différence de conductivité entre l'état cristallin et l'état amorphe.

L'invention n'est pas limitée au mode de réalisation décrit et représenté aux figures annexées. Des modifications restent possibles, notamment du point de vue de la constitution des divers caractéristiques techniques ou par substitution d'équivalents techniques, sans sortir pour autant du domaine de protection de l'invention.

## Revendications

1. Puce électronique comprenant au moins une première matrice de premières cellules élémentaires (100a) et une seconde matrice de secondes cellules élémentaires (100b), chaque cellule élémentaire (100a, 100b) stockant chacune au moins un bit de données dans un élément de stockage présentant un état fonction du bit stocké,
les deux matrices de cellules élémentaires (100a, 100b) formant deux types de mémoire à changement de phase dans lequel l'élément de stockage est formé par un volume (102a, 102b) de matériau à changement de phase configuré pour présenter soit un état cristallin soit un état amorphe en fonction du bit stocké, chaque première cellule élémentaire (100a) comprenant un volume (102a) d'un premier matériau (20), et chaque seconde cellule élémentaire (100b) comprenant un volume (102b) d'un second matériau (32, 60), différent du premier matériau, le second matériau présentant soit un état cristallin soit un état amorphe en fonction du bit stocké, chaque cellule élémentaire (100a, 100b) comprenant un connecteur de chauffe (104a, 104b,) configuré pour le passage d'un courant de chauffe adapté pour engendrer un changement de phase du volume de matériau à changement de phase de ladite cellule élémentaire (100a, 100b), **caractérisé en ce que** le second matériau a une température de fusion inférieure à une température de fusion du premier matériau d'au moins 50°C.

2. Puce électronique selon la revendication 1, dans laquelle le second matériau présente une température de fusion inférieure à la température de fusion du premier matériau d'au moins 80°C, et de préférence encore inférieure à la température de fusion du premier matériau d'au moins 120°C.

3. Puce électronique selon l'une des revendications précédentes, dans laquelle le premier matériau et le second matériau sont des chalcogénures, et de préférence sont des composés ternaires de chalcogénure.

4. Puce électronique selon la revendication 3, dans laquelle le premier matériau et le second matériau à changement de phase sont en germanium-antimoine-tellure (GeSbTe), le premier matériau présentant une teneur en germanium au moins trois fois plus importante que celle du second matériau, et le second matériau présentant une teneur en antimoine au moins trois fois plus importante que celle du premier matériau.

5. Puce électronique selon l'une quelconque des revendications précédentes, dans laquelle le premier matériau est en germanium-antimoine-tellure avec une teneur en germanium supérieure à 60%, et le second matériau est en germanium-antimoine-tellure avec une teneur en antimoine supérieure à 60%.

6. Puce électronique selon l'une quelconque des revendications précédentes, dans laquelle l'élément de stockage d'une première cellule élémentaire (100a) est constitué par le volume (102a) de premier matériau à changement de phase, et l'élément de stockage d'une seconde cellule élémentaire comprend le volume (102b) de second matériau à changement de phase.

7. Puce électronique selon la revendication 6, dans laquelle le volume (102b) de second matériau à changement de phase d'une seconde cellule élémentaire correspond à un connecteur de chauffe inférieur (104b) en contact avec un contact métallique (2b) traversant une couche d'isolation (4) .

8. Procédé de fabrication d'une puce électronique selon l'une des revendications précédentes, comprenant :
a) la fourniture d'une amorce (1) de puce électronique issue d'une fabrication comprenant une pluralité de contacts métalliques (2a, 2b, 2c) traversant une première couche d'isolation (4), une première zone (A) de la puce électronique correspondant aux premières cellules élémentaires (100a) à réaliser et une deuxième zone (B) de la puce électronique correspondant aux secondes cellules élémentaires (100b) à réaliser,
b) la réalisation sur la première couche d'isolation (4) de connecteurs de chauffe inférieurs (104a, 104b) traversant une couche intermédiaire (10) adaptée pour connecter au moins les contacts métalliques (2a) de la première zone (A), des espaceurs (18a) étant interposés entre des connecteurs de chauffe inférieurs adjacents,
c) les dépôts successifs des deux matériaux à changement de phase, le premier matériau (20) étant déposé sur la couche intermédiaire (10) au contact de connecteurs (104a) de chauffe inférieurs, et des conducteurs supérieurs (106a, 106b) étant formés au-dessus du premier matériau par le dépôt d'une seconde couche conductrice (22), tandis que le second matériau (60, 32) est déposé suite à la réalisation d'au moins d'un espace préalablement gravé (30, 14b) dans une deuxième zone (B) correspondant aux secondes cellules élémentaires en utilisant un premier masque de gravure (26) présentant une ouverture (28) au droit de ladite deuxième zone (B), le second matériau étant déposé dans cet espace (30, 14b) préalablement gravé, le second matériau étant ensuite retiré d'au moins la première zone (A),
d) gravure de séparation des premières cellules élémentaires (100a) et des secondes cellules élémentaires (100b),
e) formation de couches d'isolation entre les premières cellules élémentaires et des secondes cellules élémentaires, et métallisation formant des lignes conductrices connectant les conducteurs supérieurs (106a, 106b) des premières cellules élémentaires et des secondes cellules élémentaires.

9. Procédé selon la revendication précédente, dans lequel l'étape c) comprend les sous-étapes suivantes :
c1) dépôt du premier matériau (20) sur la couche intermédiaire (10) au contact de connecteurs de chauffe inférieurs (104a),
c2) dépôt d'une couche conductrice (22) sur le premier matériau (20), destinée à former des conducteurs supérieurs (106a) pour les premières cellules élémentaires (100a),
c3) mise en place du premier masque de gravure (26) présentant une ouverture (28) au droit de la deuxième zone (B), et gravure de la couche conductrice (22) et du premier matériau (20) pour réaliser l'espace (30) préalablement gravé au niveau de la deuxième zone (B),
c4) dépôt du second matériau (32) au niveau de la première zone (A) et de la deuxième zone (B), le second matériau (32) étant, dans la deuxième zone (B), au contact de connecteurs de chauffe inférieurs (104b), et dépôt d'une couche conductrice (34) sur le second matériau (32), destinée à former des connecteurs supérieurs (106b) pour les secondes cellules élémentaires (100b),
c5) mise en place d'un second masque de gravure (40) couvrant un espace de la deuxième zone (B) et laissant dégagée la première zone (A), et retrait du second matériau (32) de la première zone (A).

10. Procédé selon la revendication précédente, dans lequel au cours de l'étape b), les connecteurs de chauffe inférieurs (104b) sont au contact des contacts métalliques (2a, 2b) de la première zone (A) et de la deuxième zone (B) .

11. Procédé selon la revendication 8, dans lequel l'étape c) comprend les sous-étapes suivantes :
c1') mise en place du premier masque de gravure présentant une ouverture découvrant la deuxième zone (B), et gravure de la couche intermédiaire (10) jusqu'à la première couche d'isolation (4),
c2') dépôt du second matériau (60), ledit second matériau (60) étant au contact de contacts métalliques (2b) de la deuxième zone (B),
c3') retrait du second matériau (60) de la première zone (A) pour dégager la couche intermédiaire (10),
c4') dépôt du premier matériau (20) au niveau de la première zone (A) et de la deuxième (B) et dépôt d'une couche conductrice (22) sur le premier matériau (20), destinée à former des conducteurs supérieurs (106a, 106b).

12. Procédé selon la revendication précédente, dans lequel au cours de l'étape b), les connecteurs de chauffe inférieurs (104a) sont au contact des contacts métalliques (2a) de la première zone (A) seulement.

## Patentansprüche

1. Elektronischer Chip, der zumindest eine erste Anordnung von ersten Elementarzellen (100a) und eine zweite Anordnung von zweiten Elementarzellen (100b) aufweist, wobei jede Elementarzelle (100a, 100b) jeweils mindestens ein Datenbit in einem Speicherelement mit einem Zustand abhängig von dem gespeicherten Bit speichert,
wobei die zwei Anordnungen von Elementarzellen (100a, 100b) zwei Arten von Phasenänderungsspeicher bilden, wobei das Speicherelement durch ein Volumen (102a, 102b) des Phasenänderungsmaterials gebildet wird, das so konfiguriert ist, dass es entweder einen kristallinen Zustand oder einen amorphen Zustand hat, und zwar abhängig von dem gespeicherten Bit, wobei jede erste Elementarzelle (100a) ein Volumen (102a) eines ersten Materials (20) aufweist, und wobei jede zweite Elementarzelle (100b) ein Volumen (102b) eines zweiten Materials (32, 60) aufweist das sich von dem ersten Material unterscheidet, wobei das zweite Material entweder einen kristallinen Zustand oder einen amorphen Zustand hat, und zwar abhängig von dem gespeicherten Bit, wobei jede Elementarzelle (100a, 100b) einen Heizungsverbinder (104a, 104b) hat, der für das Durchleiten eines Heizungsstroms konfiguriert ist, der geeignet ist, eine Phasenänderung des Volumens des Phasenänderungsmaterials der Elementarzelle (100a, 100b) zu verursachen, **dadurch gekennzeichnet, dass** das zweite Material eine um mindestens 50° C geringere Schmelztemperatur hat als eine Schmelztemperatur des ersten Materials.

2. Elektronischer Chip nach Anspruch 1, wobei das zweite Material eine um mindestens 80° C geringere Schmelztemperatur hat als die Schmelztemperatur des ersten Materials, und wobei sie vorzugsweise zumindest 120° C niedriger ist als die Schmelztemperatur des ersten Materials.

3. Elektronischer Chip nach einem der vorhergehenden Ansprüche, wobei das erste Material und das zweite Material Chalkogenide sind und vorzugsweise ternäre Chalkogenidverbindungen sind.

4. Elektronischer Chip nach Anspruch 3, wobei das erste Phasenänderungsmaterial und das zweite Phasenänderungsmaterial aus Germanium-Antimon-Tellur (GeSbTe) gemacht sind, wobei das erste Material einen Germaniumgehalt von mindestens drei Mal mehr als jenem des zweiten Materials, und wobei das zweite Material einen Antimongehalt von mindestens drei Mal mehr als jenem des ersten Materials hat.

5. Elektronischer Chip nach einem der vorhergehenden Ansprüche, wobei das erste Material aus Germanium-Antimon-Tellur mit einem Germaniumgehalt von mehr als 60% gemacht ist, und wobei das zweite Material aus einem Germanium-Antimon-Tellur mit einem Antimongehalt von mehr als 60% gemacht ist.

6. Elektronischer Chip nach einem der vorhergehenden Ansprüche, wobei das Speicherelement einer ersten Elementarzelle (100a) durch ein Volumen (102a) des ersten Phasenänderungsmaterials gebildet ist, und wobei das Speicherelement einer zweiten Elementarzelle das Volumen (102b) des zweiten Phasenänderungsmaterials aufweist.

7. Elektronischer Chip nach Anspruch 6, wobei das Volumen (102b) des zweiten Phasenänderungsmaterials einer zweiten Elementarzelle einem unteren Heizverbinder (104b) in Kontakt mit einem Metallkontakt (2b) entspricht, der eine Isolierschicht (4) durchläuft.

8. Verfahren zur Herstellung eines elektronischen Chips nach einem der vorhergehenden Ansprüche, welches Folgendes aufweist:
a) Vorsehen eines Startelementes (1) eines elektronischen Chips aus einem Herstellungsprozess, das eine Vielzahl von Metallkontakten (2a, 2b, 2c) aufweist, welche eine erste Isolierschicht (4) durchlaufen, wobei eine erste Zone (A) des elektronischen Chips der ersten Elementarzelle (100a) entspricht, die herzustellen sind, und wobei eine zweite Zone (B) des elektronischen Chips den zweiten Elementarzellen (100b) entspricht, die herzustellen sind,
b) Herstellen der ersten Isolierschicht (4) von unteren Heizungsverbindern (104a, 104b), die eine Zwischenschicht (10) durchlaufen, die ausgebildet sind, um zumindest die Metallkontakte (2a) der ersten Zone (A) zu verbinden, wobei Abstandshalter (18a) zwischen benachbarten unteren Heizungsverbindern angeordnet sind,
c) sukzessives Ablagern der zwei Phasenänderungsmaterialien, wobei das erste Material (20) auf der Zwischenschicht (10) in Kontakt mit den unteren Heizungsverbindern (104a) abgelagert wird, und wobei obere Verbinder (106a, 106b) über dem ersten Material durch die Ablagerung einer zweiten leitenden Schicht (22) geformt werden, während das zweite Material (60, 32) folgend der Erzeugung von mindestens einem zuvor geätzten Raum (30, 14b) in einer zweiten Zone (B) abgelagert wird, welche den zweiten Elementarzellen entspricht, und zwar unter Verwendung einer Ätzmaske (26) mit einer Öffnung (28), die zu der zweiten Zone (B) weist, wobei das zweite Material in diesem Raum (30 14b) abgelagert wird, der zuvor geätzt wurde, wobei das zweite Material später zumindest aus der ersten Zone (A) entfernt wird,
d) Trennen bzw. Trennungsätzen der ersten Elementarzellen (100a) und der zweiten Elementarzellen (100b),
e) Formen von Isolierschichten zwischen den ersten Elementarzellen und den zweiten Elementarzellen und Metallisierung, wobei leitende Bahnen geformt werden, welche die oberen Verbinder ((106a, 106b) der ersten Elementarzellen und der zweiten Elementarzellen verbinden.

9. Verfahren gemäß dem vorhergehenden Anspruch, wobei der Schritt c) die folgenden Unterschritte aufweist:
c1) Ablagern des ersten Materials (20) auf der Zwischenschicht (10) in Kontakt mit den unteren Heizungsverbindern (104a),
c2) Ablagern einer leitenden Schicht (22) auf dem ersten Material (20), die vorgesehen ist, um obere Verbinder (106a) für die ersten Elementarzellen (100a) zu formen,
c3) Bereitstellen der ersten Ätzmaske (26) mit einer Öffnung (28), die zur zweiten Zone (B) weist, und Ätzen der leitenden Schicht (22) und des ersten Materials (20), um den Raum (30), der zuvor geätzt wurde, an der zweiten Zone (B) zu erzeugen,
c4) Ablagern des zweiten Materials (32) an der ersten Zone (A) und der zweiten Zone (B), wobei das zweite Material (32) in der zweiten Zone (B) in Kontakt mit den unteren Heizungsverbindern (104b) ist, und Ablagern einer leitenden Schicht (34) auf dem zweiten Material (32), die dafür vorgesehen ist, um die oberen Verbinder (106b) für die zweiten Elementarzellen (100b) zu formen,
c5) Bereitstellen einer zweiten Ätzmaske (40), die einen Raum der zweiten Zone (B) bedeckt und die erste Zone (A) freilässt, und Entfernen des zweiten Materials (32) aus der ersten Zone (A).

10. Verfahren gemäß dem vorhergehenden Anspruch, wobei während des Schrittes b) die unteren Heizverbinder (104b) in Kontakt mit den Metallkontakten (2a, 2b) der ersten Zone (A) und der zweiten Zone (B) sind.

11. Verfahren nach Anspruch 8, wobei der Schritt c) die folgenden Unterschritte aufweist:
c1') Bereitstellen der ersten Ätzmaske mit einer Öffnung, welche die zweite Zone (B) freilässt, und Ätzen der Zwischenschicht (10) herunter auf die erste Isolierschicht (4),
c2') Ablagern des zweiten Materials (60), wobei das zweite Material in Kontakt mit Metallkontakten (2b) der zweiten Zone (B) ist,
c3') Entfernen des zweiten Materials (60) von der ersten Zone (A), um die Zwischenschicht (10) freizulegen,
c4') Ablagern des ersten Materials (20) in der ersten Zone (A) und der zweiten Zone (B) und Ablagern einer leitenden Schicht (22) auf dem ersten Material (20), die vorgesehen ist, um obere Verbinder (106a, 106b) zu formen.

12. Verfahren gemäß dem vorherigen Anspruch, wobei während des Schrittes b) die unteren Heizungsverbinder (104a) in Kontakt mit nur den Metallkontakten (2a) der ersten Zone (A) sind.

## Claims

1. Electronic chip comprising at least a first array of first elementary cells (100a) and a second array of second elementary cells (100b), each elementary cell (100a, 100b) each storing at least one data bit in a storage element having a state dependent on the bit stored,
the two arrays of elementary cells (100a, 100b) forming two types of phase change memory wherein the storage element is formed by a volume (102a, 102b) of phase change material configured to have either a crystalline state or an amorphous state depending on the bit stored, each first elementary cell (100a) comprising a volume (102a) of a first material (20), and each second elementary cell (100b)comprising a volume (102b) of a second material (32, 60), different from the first material, the second material having either a crystalline state or an amorphous state depending on the bit stored, each elementary cell (100a, 100b) comprising a heating connector (104a, 104b,) configured for the passage of a heating current adapted to cause a phase change of the volume of phase change material of said elementary cell (100a, 100b),
**characterized in that** the second material has a melting temperature lower than a melting temperature of the first material by at least 50°C.

2. Electronic chip according to claim 1, wherein the second material has a melting temperature lower than the melting temperature of the first material by at least 80°C, and further preferably lower than the melting temperature of the first material by at least 120°C.

3. Electronic chip according to one of the previous claims, wherein the first material and the second material are chalcogenides, and preferably are ternary chalcogenide compounds.

4. Electronic chip according to claim 3, wherein the first phase change material and the second phase change material are made of germanium-antimony-tellurium (GeSbTe), the first material having a germanium content at least three times greater than that of the second material, and the second material having an antimony content at least three times greater than that of the first material.

5. Electronic chip according to one of the previous claims, wherein the first material is made of germanium-antimony-tellurium with a germanium content greater than 60%, and the second material is made of germanium-antimony-tellurium with an antimony content greater than 60%.

6. Electronic chip according to one of the previous claims, wherein the storage element of a first elementary cell (100a) is constituted by the volume (102a) of first phase change material, and the storage element of a second elementary cell comprises the volume (102b) of second phase change material.

7. Electronic chip according to claim 6, wherein the volume (102b) of second phase change material of a second elementary cell corresponds to a lower heating connector (104b) in contact with a metal contact (2b) traversing an insulating layer (4).

8. Method for manufacturing an electronic chip according to one of the previous claims, comprising:
a) providing a starter (1) of an electronic chip from a manufacturing process comprising a plurality of metal contacts (2a, 2b, 2c) traversing a first insulating layer (4), a first zone (A) of the electronic chip corresponding to the first elementary cells (100a) to produce and a second zone (B) of the electronic chip corresponding to the second elementary cells (100b) to produce,
b) the production on the first insulating layer (4) of lower heating connectors (104a, 104b) traversing an intermediate layer (10) adapted to connect at least the metal contacts (2a) of the first zone (A), spacers (18a) being interposed between adjacent lower heating connectors,
c) the successive depositions of the two phase change materials, the first material (20) being deposited on the intermediate layer (10) in contact with the lower heating connectors (104a), and upper conductors (106a, 106b) being formed above the first material by the deposition of a second conductive layer (22), whereas the second material (60, 32) is deposited following the production of at least one space etched beforehand (30, 14b) in a second zone (B) corresponding to the second elementary cells using a first etching mask (26) having an opening (28) facing said second zone (B), the second material being deposited in this space (30, 14b) etched beforehand, the second material being later removed from at least the first zone (A),
d) separation etching of the first elementary cells (100a) and the second elementary cells (100b),
e) formation of insulating layers between the first elementary cells and the second elementary cells, and metallisation forming conductive lines connecting the upper conductors (106a, 106b) of the first elementary cells and the second elementary cells.

9. Method according to the previous claim, wherein step c) comprises the following sub-steps:
c1) deposition of the first material (20) on the intermediate layer (10) in contact with the lower heating connectors (104a),
c2) deposition of a conductive layer (22) on the first material (20), intended to form upper conductors (106a) for the first elementary cells (100a),
c3) putting in place the first etching mask (26) having an opening (28) facing the second zone (B), and etching of the conductive layer (22) and the first material (20) to produce the space (30) etched beforehand at the second zone (B),
c4) deposition of the second material (32) at the first zone (A) and the second zone (B), the second material (32) being, in the second zone (B), in contact with the lower heating connectors (104b), and deposition of a conductive layer (34) on the second material (32), intended to form upper connectors (106b) for the second elementary cells (100b),
c5) putting in place a second etching mask (40) covering a space of the second zone (B) and leaving free the first zone (A), and removal of the second material (32) from the first zone (A).

10. Method according to the previous claim, wherein during step b), the lower heating connectors (104b) are in contact with the metal contacts (2a, 2b) of the first zone (A) and the second zone (B).

11. Method according to claim 8, wherein step c) comprises the following sub-steps:
c1') putting in place the first etching mask having an opening uncovering the second zone (B), and etching of the intermediate layer (10) down to the first insulating layer (4),
c2') deposition of the second material (60), said second material (60) being in contact with metal contacts (2b) of the second zone (B),
c3') removal of the second material (60) from the first zone (A) to free the intermediate layer (10),
c4') deposition of the first material (20) at the first zone (A) and the second zone (B) and deposition of a conductive layer (22) on the first material (20), intended to form upper conductors (106a, 106b).

12. Method according to the previous claim, wherein during step b), the lower heating connectors (104a) are in contact with the metal contacts (2a) of the first zone (A) only.
